# EUROPÄISCHE PATENTSCHRIFT

(11) **EP 3 216 671 B1**
(45) Veröffentlichungstag und Bekanntmachung des Hinweises auf die Patenterteilung: **05.05.2021**
(21) Anmeldenummer: 17160097.6
(22) Anmeldetag: 09.03.2017
(51) Int. Cl.: B61D 27/00, H05K 7/20, B61D 17/04

(54) **KÜHLSYSTEM EINES FAHRZEUGS**
COOLING SYSTEM OF A VEHICLE
SYSTÈME DE REFROIDISSEMENT D'UN VÉHICULE

(30) Priorität: 10.03.2016 DE 102016203977
(43) Veröffentlichungstag der Anmeldung: 13.09.2017
(73) Patentinhaber: Mahle International GmbH, 70376 Stuttgart (DE)
(72) Erfinder: Frank, Stefan, 70839 Gerlingen (DE)
(74) Vertreter: BRP Renaud & Partner mbB Rechtsanwälte Patentanwälte Steuerberater

(56) Entgegenhaltungen:
- EP-A1- 0 638 712
- WO-A1-03/046457
- WO-A1-2005/061869
- DE-A1-102007 005 391
- DE-A1-102008 011 225
- DE-A1-102010 015 331
- DE-A1-102014 004 009
- DE-T5-112013 003 619

## Beschreibung

Die vorliegende Erfindung betrifft ein Kühlsystem eines Fahrzeugs, insbesondere eines Schienenfahrzeugs, gemäß dem Oberbegriff des Anspruchs 1.

Fahrzeuge weisen eine Vielzahl von Komponenten auf, die im Betrieb, insbesondere beim Antrieb des Fahrzeugs, Wärme entwickeln und/oder einer Kühlung bedürfen. Diese Komponenten sind dabei als Wärmequellen zu betrachten, die mittels eines Kühlsystems gekühlt werden. Unterschiedliche Wärmequellen können hierbei jeweils einen unterschiedlichen Kühlbedarf erfordern. Bei einem als Schienenfahrzeug ausgestalteten Fahrzeug, das insbesondere elektrisch angetrieben ist, sind derartige Wärmequellen bspw. Stromrichter, Induktivitäten, Fahrmotoren und dergleichen. Der Kühlbedarf der jeweiligen Komponenten ist hierbei hinsichtlich der Einbindung im Kühlsystem sowie der Versorgung innerhalb des Kühlsystems zu beachten. Derartige Kühlsysteme sind üblicherweise von einem Kühlmittel durchströmt, das in einem entsprechenden Kühlkreis zirkuliert. Bedarf eine Wärmequelle eine stärkere Kühlung, so muss das Kühlmittel mit einer niedrigeren Kühltemperatur und/oder einem größeren Volumenstrom zu dieser Wärmequelle geführt werden, als zu einer Wärmequelle, die einer niedrigeren Kühlung bedarf.

Hierzu ist es vorstellbar, die Wärmequellen in einem gemeinsamen Kühlkreis zwecks Kühlung einzubinden, in der eine Fördereinrichtung zum Fördern des Kühlmittels angeordnet ist. In einem solchen Kühlkreis ist dabei ein Kühler zum Kühlen des Kühlmittels vorgesehen. Zur Berücksichtigung des unterschiedlichen Kühlbedarfs unterschiedlicher Wärmequellen ist es vorstellbar, die Wärmequelle mit dem höheren Kühlbedarf in Strömungsrichtung des Kühlmittels stromauf der Wärmequelle mit dem niedrigeren Kühlbedarf anzuordnen. Dies erfordert, dass das Kühlmittel vor dem Eintritt in die Wärmequelle mit dem höheren Kühlbedarf eine entsprechende Temperatur aufweist, so dass der gesamte Kühlkreis an die Kühlbedürfnisse der Wärmequelle mit dem höchsten Kühlbedarf anzupassen ist. Auch erfordert dies, dass die nachfolgend angeordneten Wärmequellen mit Kühlmittel einer vorgegeben Mindesttemperatur versorgt werden. Insgesamt führt dies zu einer entsprechend hohen Anforderung an die Kühlung des Kühlmittels mittels des Kühlers, die insbesondere zu einer entsprechend großen Dimensionierung des Kühlers führt.

Aus der DE 43 27 261 C1 ist ein Kühlsystem bekannt, bei dem die Wärmequellen jeweils in einem separaten Kühlkreis angeordnet sind. Dies führt zu einer individuellen Abstimmung des jeweiligen Kühlkreises mit der zugehörigen Wärmequelle. Nachteilig dabei ist, dass zwei separate Kühlkreise mit entsprechend separaten Komponenten vorzusehen sind, welche den Bauraumbedarf und/oder die Anzahl der einzelnen Komponenten und/oder das Gewicht des Kühlsystems erhöhen

Das Dokument DE 112013003619 T5 beschreibt ein Kühlsystem eines Fahrzeugs mit einem ersten Kühlkreis, in dem ein Kühlmittel zirkuliert, und mit einem zweiten Kühlkreis, in dem das Kühlmittel zirkuliert, und mit einer zur Kühlung im ersten Kühlkreis angeordneten ersten Wärmequelle, der Brennkraftmaschine, mit einer zur Kühlung im zweiten Kühlkreis angeordneten zweiten Wärmequelle, wobei das Kühlsystem einen Kühler aufweist, welcher geeignet ist zum Kühlen des Kühlmittels im ersten Kühlkreis und im zweiten Kühlkreis, und wobei das Kühlsystem einen Hauptzweig aufweist, in dem der erste Kühlkreis und der zweite Kühlkreis gemeinsam geführt sind, und wobei im Hauptzweig eine Fördereinrichtung zum Fördern des Kühlmittels angeordnet ist, und wobei der erste Kühlkreis und der zweite Kühlkreis stromab der Fördereinrichtung aus dem Hauptzweig abzweigen.

Die vorliegende Erfindung beschäftigt sich daher mit dem Problem, für ein Kühlsystem der eingangs genannten Art eine verbesserte oder zumindest alternative Ausführungsform anzugeben, die sich insbesondere durch einen reduzierten Bauraumbedarf und/oder durch ein reduziertes Gewicht und/oder durch eine erhöhte Effizienz auszeichnet.

Dieses Problem wird erfindungsgemäß durch den Gegenstand des unabhängigen Anspruchs 1 gelöst. Vorteilhafte Ausführungsformen sind Gegenstand der abhängigen Ansprüche.

Die vorliegende Erfindung beruht auf dem allgemeinen Gedanken, bei einem Kühlsystem mit zwei Kühlkreisen, in denen das gleiche Kühlmittel zirkuliert, eine gemeinsame Fördereinrichtung zum Fördern des Kühlmittels in beiden Kühlkreisen vorzusehen. Dabei ist im jeweiligen Kühlkreis eine zugehörige Wärmequelle zwecks Kühlung derselben angeordnet. Hierdurch ist es möglich, die Kühlung im jeweiligen Kühlkreis an die zugehörige Wärmequelle anzupassen und gleichzeitig die Anzahl der benötigten Komponenten des Kühlsystems und somit das Gewicht und/oder den Bauraum zu reduzieren. Der Einsatz einer gemeinsamen Fördereinrichtung zum Fördern des Kühlmittels in beiden Kühlkreisen erfordert einen reduzierten Energiebedarf des Kühlsystems und ermöglicht somit eine erhöhte Effizienz des Kühlsystems. Dem Erfindungsgedanken entsprechend weist das Kühlsystem einen ersten Kühlkreis und einen zweiten Kühlkreis auf, wobei in beiden Kühlkreisen Kühlmittel zirkuliert. Im jeweiligen Kühlkreis ist eine solche Wärmequelle zwecks Kühlung angeordnet bzw. eingebunden. Das heißt, dass im ersten Kühlkreis eine erste Wärmequelle angeordnet ist, die mittels des ersten Kühlkreises, das heißt mittels des im ersten Kühlkreis zirkulierenden Kühlmittels, gekühlt wird. Analog hierzu ist im zweiten Kühlkreis eine zweite Wärmequelle angeordnet bzw. eingebunden, die mittels des zweiten Kühlkreises, das heißt mittels des im zweiten Kühlkreis zirkulierenden Kühlmittels gekühlt wird. Das Kühlsystem weist zudem einen gemeinsamen Kühler zum Kühlen des Kühlmittels im ersten Kühlkreis und im zweiten Kühlkreis auf. Erfindungsgemäß ist vorgesehen, dass das Kühlsystem einen Hauptzweig aufweist, in dem der erste Kühlkreis und der zweite Kühlkreis gemeinsam geführt sind, wobei im Hauptzweig eine gemeinsame Fördereinrichtung zum Fördern des Kühlmittels im Hauptzweig und damit im ersten Kühlkreis und im ersten Kühlkreis angeordnet ist. Der erste Kühlkreis und der zweite Kühlkreis zweigen hierbei stromab der Fördereinrichtung aus dem Hauptzweig ab. Bevorzugt ist es dabei, wenn die Wärmequellen des jeweiligen Kühlkreises außerhalb des Hauptzweiges, das heißt stromauf und/oder stromab des Hauptzweiges angeordnet sind Erfindungsgemäß ist vorgesehen, dass die Kühlkreise innerhalb des Kühlers gänzlich getrennt geführt sind.

Das Kühlsystem kommt bevorzugt in einem Fahrzeug zum Einsatz. Das Kühlsystem kommt hierbei insbesondere zum Kühlen von Antriebskomponenten des Fahrzeugs zum Einsatz. Das heißt, dass besagte Wärmequellen, die zwecks Kühlung im jeweiligen Kühlkreis angeordnet sind, Antriebskomponenten des Fahrzeugs sind. Das Fahrzeug kann hierbei beliebig ausgestaltet sein. Das Fahrzeug ist insbesondere ein Schienenfahrzeug. Dabei ist das Fahrzeug insbesondere elektrisch angetrieben. Das heißt, dass das Fahrzeug ein elektrisch angetriebenes Schienenfahrzeug sein kann.

Die Kühlung der jeweiligen Wärmequelle mittels des Kühlmittels kann durch eine wärmeübertragende Kopplung des Kühlmittels mit der Wärmequelle realisiert sein. Bevorzugt ist es hierbei, wenn die jeweilige Wärmequelle vom Kühlmittel durchströmt und/oder umströmt ist.

Prinzipiell ist es vorstellbar, die Fördereinrichtung bezüglich des Kühlers beliebig anzuordnen, sofern die Fördereinrichtung im Hauptzweig angeordnet ist.

Zu denken ist an Varianten, bei denen die Fördereinrichtung stromab des Kühlers angeordnet ist. In der Folge zweigen der erste Kühlkreis und der zweite Kühlkreis ebenfalls stromab des Kühlers vom Hauptzweig ab. Dabei ist es insbesondere vorstellbar, den Hauptzweig gänzlich stromab des Kühlers anzuordnen. Das heißt, dass der erste Kühlkreis und der zweite Kühlkreis stromab des Kühlers in dem Hauptzweig zusammengeführt sind und stromab des Kühlers sowie stromab der Fördereinrichtung aus dem Hauptzweig abzweigen.

Vorstellbar sind auch Ausführungsformen, bei denen die Fördereinrichtung stromauf des Kühlers angeordnet ist. Das heißt insbesondere, dass die Kühlkreise stromauf des Kühlers im Hauptzweig zusammengeführt sind. Zu denken ist dabei an Varianten, bei denen der Hauptzweig gänzlich stromauf des Kühlers angeordnet ist. Das heißt, dass der erste Kühlkreis und der zweite Kühlkreis stromauf des Kühlers aus dem Hauptzweig abzweigen. Vorstellbar ist es auch, dass der erste Kühlkreis und der zweite Kühlkreis stromab des Kühlers vom Hauptzweig abzweigen. In diesem Fall erstreckt sich der Hauptzweig also durch den Kühler hindurch.

Bei bevorzugten Ausführungsformen ist der Kühler als ein Zirkulationskühler ausgebildet, durch den das Kühlmittel in Zirkulationsschleifen mehrmals zirkulieren kann. Durch die aufeinanderfolgende Zirkulation erfolgt eine zunehmende Kühlung des Kühlmittels, so dass der Zirkulationskühler mit steigernder Anzahl der Zirkulationsschleifen das Kühlmittel stärker kühlt. Die Zirkulation des Kühlmittels in den Zirkulationsschleifen erfolgt dabei bevorzugt innerhalb des Kühlers. Hierzu können entsprechende Umlenkmittel vorgesehen sein. Dabei ist im Kühler für den ersten Kühlkreis eine höhere Anzahl an Zirkulationen bzw. mehr Zirkulationsschleifen vorgesehen als für den zweiten Kühlkreis. Dabei ist die Anzahl der Zirkulationen nicht zwingend ganzzahlig. In der Folge wird das Kühlmittel für den ersten Kühlkreis im Kühler stärker gekühlt als im zweiten Kühlkreis.

Gemäß bevorzugter Ausführungsformen zweigt der jeweilige Kühlkreis bei einem solchen Zirkulationskühler unmittelbar vom Zirkulationskühler ab. Das heißt, dass der Hauptzweig bis in den Zirkulationskühler hinein und entsprechend der jeweiligen Abzweigung der Kühlkreise verläuft. Je nach gewünschter Kühlung, verlässt der jeweilige Kühlkreis den Kühler nach mehr oder weniger Zirkulationsschleifen.

Die Kühlung des Kühlmittels im Kühler kann prinzipiell beliebig ausgestaltet sein. Bevorzugt ist es hierbei, wenn der Kühler zum Kühlen des Kühlmittels von einem Kühlfluid durchströmt ist. Das Kühlfluid durchströmt den Kühler dabei in einer Kühlfluid-Strömungsrichtung. Das Kühlfluid zum Kühlen des Kühlers kann bspw. durch eine zugehörige Strömungsmaschine bereitgestellt werden.

Das Kühlfluid kann insbesondere Luft sein. Die Luft wird also insbesondere durch eine solche Strömungsmaschine, bspw. durch einen Ventilator und dgl., bereitgestellt. Vorstellbar ist es auch, zwecks Kühlung des Kühlmittels im Kühler Fahrtwind bzw. Fahrtluft des zugehörigen Fahrzeugs einzusetzen.

Die Kühlkreise sind innerhalb des Kühlers gänzlich getrennt geführt. Dies erlaubt eine individuell an den jeweiligen Kühlkreis bzw. die zugehörige Wärmequelle angepasste Kühlung des Kühlmittels im Kühler.

Gemäß vorteilhafter Ausführungsformen ist der erste Kühlkreis im Kühler in Kühlfluid-Strömungsrichtung stromauf des zweiten Kühlkreises geführt. Das heißt, dass das Kühlfluid zunächst mit dem Kühlmittel im ersten Kühlkreis und anschließend mit dem Kühlmittel im zweiten Kühlkreis Wärme austauscht. Hierdurch kann es insbesondere zu einer stärkeren Kühlung des Kühlmittels im ersten Kühlkreis kommen als im zweiten Kühlkreis. Dadurch ist es möglich, die im ersten Kühlkreis angeordnete erste Wärmequelle stärker zu kühlen als die im zweiten Kühlkreis angeordnete zweite Wärmequelle. Hierdurch ist es auch möglich, im ersten Kühlkreis eine solche Wärmequelle mit einem höheren Kühlbedarf anzuordnen und im zweiten Kühlkreis eine solche Wärmequelle mit einem niedrigeren Kühlbedarf.

Bevorzugt ist es, wenn die erste Wärmequelle einen höheren Kühlbedarf aufweist als die zweite Wärmequelle. Dabei kann die jeweilige Wärmequelle eine Antriebskomponente des Fahrzeugs sein. Zu denken ist hierbei insbesondere an Stromrichter, Induktivitäten (Saugkreisdrossel), Fahrmotoren und dgl. Die erste Wärmequelle weist bspw. eine Halbleiterkomponente auf oder ist als eine solche Halbleiterkomponente ausgebildet. Die zweite Wärmequelle weist bspw. eine induktive Komponente auf oder ist als eine solche induktive Komponente ausgebildet, die in der Regel einen niedrigeren Kühlbedarf aufweist als Halbleiterkomponenten.

Das Kühlsystem kann auch weitere Kühlkreise aufweisen. Dabei ist es vorstellbar, dass in einem weiteren solchen Kühlkreis das Kühlmittel zirkuliert, wobei in dem Kühlkreis eine weitere Wärmequelle zwecks Kühlung angeordnet ist. Dieser weitere Kühlkreis kann im Hauptzweig mit dem ersten Kühlkreis und dem zweiten Kühlkreis gemeinsam geführt sein und stromab der Fördereinrichtung aus dem Hauptzweig abzweigen. Das heißt, dass die Fördereinrichtung zum Fördern des Kühlmittels im ersten Kühlkreis, im zweiten Kühlkreis und dem weiteren Kühlkreis zum Einsatz kommen kann.

Die Kühlkreise können prinzipiell an einer gemeinsamen Abzweigstelle vom Hauptzweig abzweigen. Vorstellbar sind auch Ausführungsformen, bei denen zumindest zwei der Kühlkreise an unterschiedlichen Abzweigstellen vom Hauptzweig abzweigen. Entsprechendes gilt für das Zusammenführen der Kühlkreise, die an einer gemeinsamen Koppelstelle oder an unterschiedlichen Koppelstellen zusammengeführt sein können.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Komponenten beziehen.

Es zeigen, jeweils schematisch, stark vereinfacht und schaltplanartige,
- Fig. 1: ein Fahrzeug mit einem Kühlsystem,
- Fig. 2: das Fahrzeug bei einem anderen Ausführungsbeispiel des Kühlsystems,
- Fig. 3, 4: das Fahrzeug bei einem weiteren Ausführungsbeispiel.

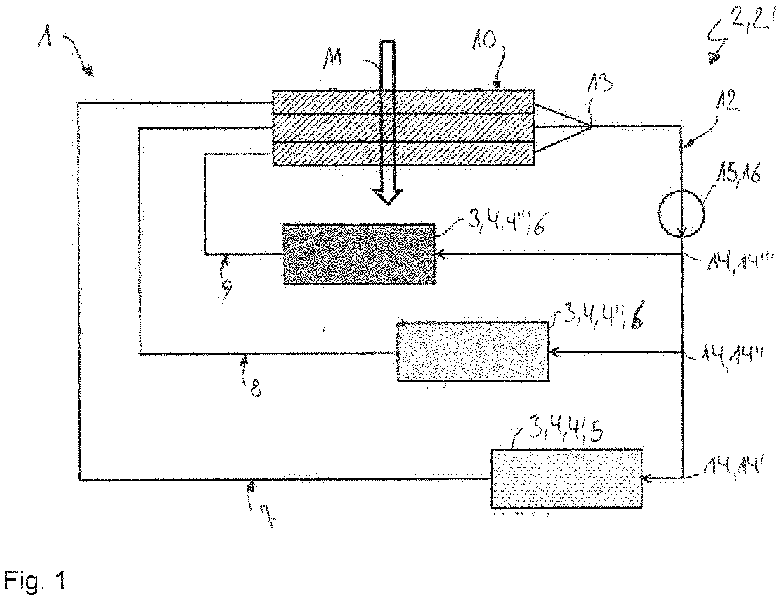

Fig. 1 zeigt ein Kühlsystem 1 eines im Übrigen nicht dargestellten Fahrzeugs 2, insbesondere eines elektrisch angetriebenen Schienenfahrzeugs 2'. Das Fahrzeug 2 weist beispielsweise verschiedene Antriebskomponenten 3 auf, die als Wärmequellen 4 mit Hilfe des Kühlsystems 1 gekühlt werden. Im gezeigten Beispiel sind drei solche Wärmequellen 4, nämlich eine erste Wärmequelle 4', eine zweite Wärmequelle 4" sowie eine dritte Wärmequelle 4"', vorgesehen. Die erste Wärmequelle 4' kann eine Halbleiterkomponente 5 sein, während die zweite Wärmequelle 4" und die dritte Wärmequelle 4"' jeweils eine induktive Komponente 6 sein können. Das Kühlsystem 1 weist für die jeweilige Wärmequelle 4 einen zugehörigen Kühlkreis 7, 8, 9 auf. Die erste Wärmequelle 4' ist dabei in einem ersten Kühlkreis 7 angeordnet bzw. eingebunden, während die zweite Wärmequelle 4" in einen zweiten Kühlkreis 8 und die dritte Wärmequelle 4"' in einen dritten Kühlkreis 9 eingebunden sind. In den Kühlkreisen 7, 8, 9 zirkuliert ein Kühlmittel, mit dem die jeweilige Wärmequelle 4 gekühlt wird. Hierdurch durchströmt und/oder umströmt das Kühlmittel die zugehörige Wärmequelle 4. Zum Kühlen des Kühlmittels der Kühlkreise 7, 8, 9 weist das Kühlsystem 1 einen gemeinsamen Kühler 10 auf, durch den das Kühlmittel zwecks Kühlung strömt.

Die Kühlung des Kühlmittels im Kühler 10 erfolgt durch Wärmeaustausch mit einem Kühlfluid, insbesondere mit Luft, bspw. Fahrtwind, das den Kühler 10 durchströmt. Im gezeigten Beispiel wird der Kühler 10 dabei in einer Kühlfluid-Strömungsrichtung 11 vom Kühlfluid durchströmt. Die Kühlkreise 7, 8, 9 sind im gezeigten Beispiel getrennt durch den Kühler 10 geführt, wobei der erste Kühlkreis 7 bezüglich der Kühlfluid-Strömungsrichtung 11 stromauf des zweiten Kühlkreises 8 durch den Kühler 10 geführt ist, während der dritte Kühlkreis 9 bezüglich der Kühlfluid-Strömungsrichtung 11 stromab des zweiten Kühlkreises 8 durch den Kühler 10 geführt ist. Hierdurch wird das Kühlfluid im ersten Kühlkreis 7 im Kühler 10 stärker gekühlt als das Kühlfluid im zweiten Kühlkreis 8, das wiederum stärker gekühlt wird als das Kühlfluid im dritten Kühlkreis 9.

Das Kühlsystem 1 weist einen Hauptzweig 12 auf, in dem der erste Kühlkreis 7, der zweite Kühlkreis 8 sowie der dritte Kühlkreis 9 gemeinsam geführt sind. Dabei sind die Kühlkreise 7, 8, 9 in einer gemeinsamen Koppelstelle 13 des Hauptzweigs 12 zusammengeführt und zweigen an jeweils zugehörigen Abzweigstellen 14 aus dem Hauptzweig 12 ab. Das heißt, dass die Kühlkreise 7, 8, 9 im gezeigten Beispiel in einer gemeinsamen Koppelstelle 13 zusammengeführt sind, wobei der erste Kühlkreis 7 an einer ersten Abzweigstelle 14' aus dem Hauptzweig 12 abzweigt, während der zweite Kühlkreis 8 an einer zweiten Abzweigstelle 14" aus dem Hauptzweig 12 abzweigt und der dritte Kühlkreis 9 an einer dritten Abzweigstelle 14"' aus dem Hauptzweig 12 abzweigt. Erfindungsgemäß ist im Hauptzweig 12 eine gemeinsame Fördereinrichtung 15, bspw. eine Pumpe 16, zum Fördern des Kühlmittels in den Kühlkreisen 7, 8, 9 vorgesehen. Die Fördereinrichtung 15 ist stromab der gemeinsamen Kopplungsstelle 13 und stromauf der Abzweigstellen 14 angeordnet. Hierdurch wird das Kühlmittel in allen Kühlkreisen 7, 8, 9 mittels der gemeinsamen Fördereinrichtung 15 gefördert. Das heißt, dass den Kühlkreisen 7, 8, 9 eine solche gemeinsame Fördereinrichtung 15 zugeordnet ist. In der Folge lassen sich der Bauraum für das Kühlsystem 1 und/oder das Gewicht des Kühlsystems 1 reduzieren. Zudem kann das Kühlsystem 1 aufgrund der gemeinsamen Fördereinrichtung 15 sparsamer bzw. effizienter betrieben werden. Die getrennte Führung der Kühlkreise 7, 8, 9 durch den Kühler 10 sowie deren Anordnung bezüglich der Kühlfluid-Strömungsrichtung 11 erlaubt ferner eine effiziente Kühlung der Wärmequellen 4 im jeweiligen Kühlkreis 7, 8, 9.

Das Kühlmittel verlässt in dem Beispiel nach Fig. 1 den Kühler 10 beispielsweise mit ca. 60 °C und wird durch die erste Wärmequelle 4' auf ca. 65 °C, durch die zweite Wärmequelle 4" auf ca. 75 °C und durch die dritte Wärmequelle 4"' auf ca. 80 °C erwärmt.

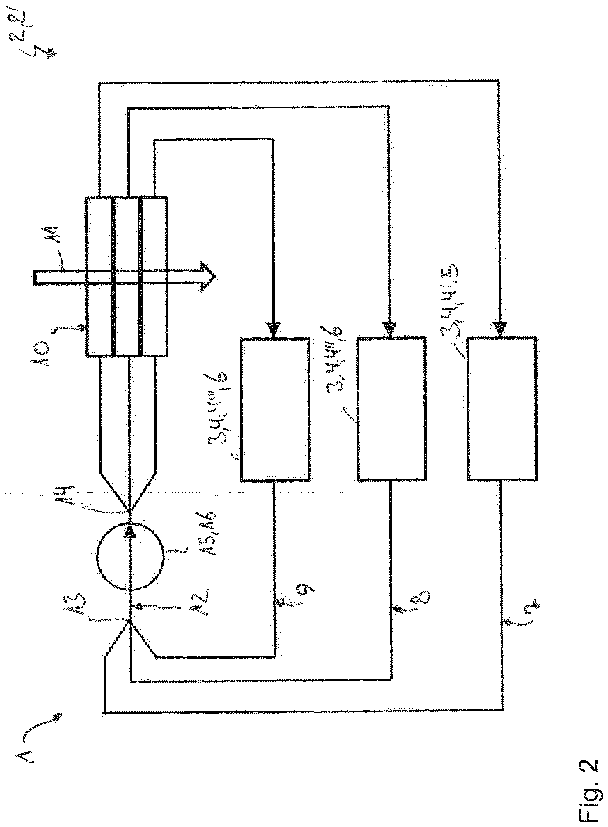

In Fig. 2 ist ein weiteres Ausführungsbeispiel des Kühlsystems 1 des Fahrzeugs 2 gezeigt. Dieses Ausführungsbeispiel unterscheidet sich von dem in Fig. 1 gezeigten Ausführungsbeispiel insbesondere dadurch, dass die Kühlkreise 7, 8, 9 in einer gemeinsamen solchen Abzweigstelle 14 aus dem Hauptzweig 12 abzweigen. Zudem sind die gemeinsame Kopplungsstelle 13 und die gemeinsame Abzweigstelle 14 stromauf des Kühlers 10 angeordnet, so dass auch die Fördereinrichtung 15 und der Hauptzweig 12 stromauf des Kühlers 10 angeordnet sind. Bei diesem Ausführungsbeispiel kann im Vergleich zum in Fig. 1 gezeigten Ausführungsbeispiel die jeweilige Wärmequelle 4, insbesondere aufgrund der getrennten Führung der Kühlkreise 7, 8, 9 durch den Kühler 10 sowie deren Anordnung relativ zur Kühlfluid-Strömungsrichtung 11 mit Kühlmittel unterschiedlicher Temperatur beaufschlagt werden. Insbesondere kann die erste Wärmequelle 4' im ersten Kühlkreis 7 mit Kühlmittel niedrigerer Temperatur beaufschlagt werden als die zweite Wärmequelle 4" im zweiten Kühlkreis 8, die wiederum mit Kühlmittel niedrigerer Temperatur beaufschlagt werden kann als die dritten Wärmequelle 4"' im dritten Kühlkreis 9.

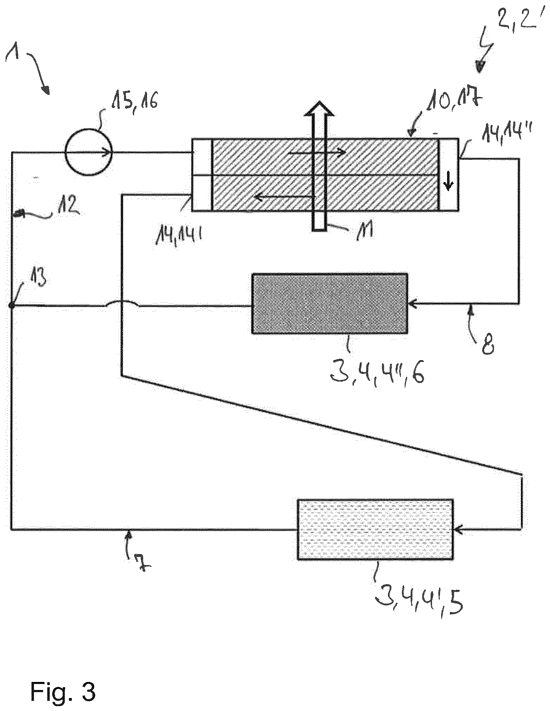

Ein weiteres Ausführungsbeispiel ist in Fig. 3 dargestellt. Bei diesem Ausführungsbeispiel sind lediglich zwei solche Kühlkreise 7, 8, nämlich der erste Kühlkreis 7 und der zweite Kühlkreis 8, vorgesehen. Der erste Kühlkreis 7 und der zweite Kühlkreis 8 sind in einer solchen gemeinsamen Kopplungsstelle 13 zusammengeführt. Die Fördereinrichtung 15 ist stromauf des Kühlers 10 angeordnet. Der Kühler 10 ist als ein Zirkulationskühler 17 ausgebildet, durch den das Kühlmittel in Zirkulationsschleifen mehrmals zirkulieren kann, bevor es zum zugehörigen Kühlkreis 7, 8 gelangt. Im gezeigten Beispiel zweigen die Kühlkreise 7, 8 am Kühler 10 vom Hauptzweig 12 ab. Das heißt, dass der Hauptzweig 12 in den Kühler 10 hinein verläuft. Beim gezeigten Beispiel sind die erste Abzweigstelle 14', an der der erste Kühlkreis 7 aus dem Hauptzweig 12 abzweigt und die zweite Abzweigstelle 14", an der der zweite Kühlkreis 8 aus dem Hauptzweig 12 abzweigt, am Kühler 10 angeordnet. Dabei sind im als Zirkulationskühler 17 ausgebildeten Kühler 10 für den ersten Kühlkreis 7 mehr Zirkulationsschleifen vorgesehen als für den zweiten Kühlkreis 8. Das heißt, dass eine Anzahl von Zirkulationen des Kühlmittels für den ersten Kühlkreis 7 durch den Zirkulationskühler 17 größer ist als die Anzahl von Zirkulationen für das Kühlmittel des zweiten Kühlkreises 8, wobei die jeweilige Anzahl nicht zwangsläufig ganzzahlig sein muss. Im gezeigten Ausführungsbeispiel zweigt der zweite Kühlkreis 8 an der zweiten Abzweigstelle 14" bereits nach einmaligem Durchströmen des Kühlmittels durch den Kühler 10 vom Kühler 10 ab, während der erste Kühlkreis 7 an der ersten Abzweigstelle 14' den Kühler 10 in entgegengesetzten Richtungen durchströmt, bevor es an der ersten Abzweigstelle 14' vom Kühler 10 abzweigt. Somit wird das Kühlmittel für den ersten Kühlkreis 7 im Kühler 10 stärker gekühlt als das Kühlmittel für den zweiten Kühlkreis 8. Zudem strömt das zur ersten Abzweigstelle 14' gelangende Kühlmittel zusätzlich bezüglich der Kühlfluid-Strömungsrichtung 11 stromauf durch den Kühler 10, so dass das Kühlmittel für den ersten Kühlkreis 7 auch hierdurch stärker gekühlt wird als das Kühlmittel für den zweiten Kühlkreis 8.

Das Kühlmittel verlässt in dem Beispiel nach Fig. 3 den Kühler 10 an der Abzweigstelle 14, 14" in den zweiten Kühlkreis 8 mit ca. 70 °C und wird durch die zweite Wärmequelle 4" auf ca. 90 °C erwärmt. Nach einer weiteren Zirkulationsschleife durch den Kühler 10 verlässt das Kühlmittel den Kühler 10 in den ersten Kühlkreis 7 mit ca. 60 °C und wird durch die erste Wärmequelle 4' auf ca. 65 °C erwärmt.

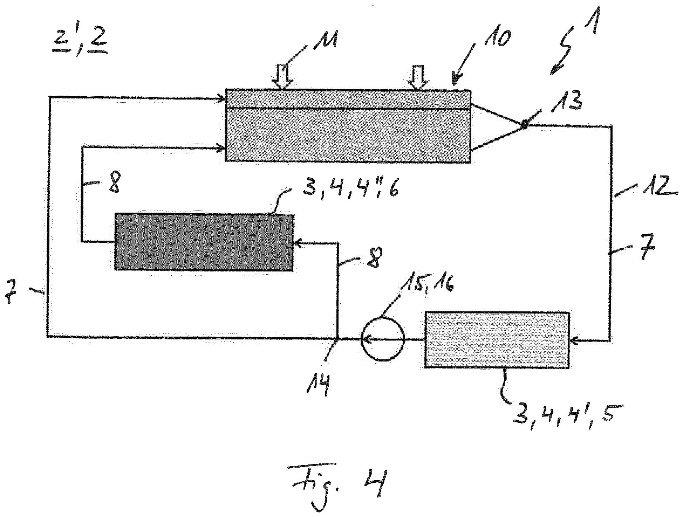

Fig. 4 zeigt ebenfalls ein Kühlsystem 1 eines im Übrigen nicht dargestellten Fahrzeugs 2, insbesondere eines elektrisch angetriebenen Schienenfahrzeugs 2'.

Das Fahrzeug 2 weist verschiedene Wärmequellen 4, 4', 4" auf, die mit Hilfe des Kühlsystems 1 gekühlt werden. Im gezeigten Beispiel sind zwei solche Wärmequellen 4, nämlich eine erste Wärmequelle 4', eine zweite Wärmequelle 4" sowie eine dritte Wärmequelle 4"', vorgesehen. Die erste Wärmequelle 4' kann eine Halbleiterkomponente 5 sein, während die zweite Wärmequelle 4" eine induktive Komponente 6 sein können. Das Kühlsystem 1 weist für die jeweilige Wärmequelle 4', 4" einen zugehörigen Kühlkreis 7, 8 auf. Die erste Wärmequelle 4' ist dabei im ersten Kühlkreis 7 angeordnet, während die zweite Wärmequelle 4" in den zweiten Kühlkreis 8 eingebunden ist. In den Kühlkreisen 7, 8, zirkuliert ein Kühlmittel, mit dem die jeweilige Wärmequelle 4 gekühlt und das im gemeinsamen Kühler 10 gekühlt wird. Die Kühlkreise 7, 8 sind dabei getrennt durch den Kühler 10 geführt, wobei der erste Kühlkreis 7 bezüglich der Kühlfluid-Strömungsrichtung 11 stromauf des zweiten Kühlkreises 8 durch den Kühler 10 geführt ist. Hierdurch wird das Kühlfluid im ersten Kühlkreis 7 im Kühler 10 stärker gekühlt als das Kühlfluid im zweiten Kühlkreis 8.

Das Kühlsystem 1 weist ebenfalls einen Hauptzweig 12 auf, in dem der erste Kühlkreis 7 und der zweite Kühlkreis 8 gemeinsam geführt sind. Dabei sind die Kühlkreise 7, 8 in der Koppelstelle 13 des Hauptzweigs 12 zusammengeführt und zweigen an der Abzweigstelle 14 aus dem Hauptzweig 12 ab. Auch in diesem Beispiel ist im Hauptzweig 12 eine gemeinsame Fördereinrichtung 15, bspw. eine Pumpe 16, zum Fördern des Kühlmittels in den Kühlkreisen 7, 8 vorgesehen. Die Fördereinrichtung 15 ist stromab der gemeinsamen Kopplungsstelle 13 und stromauf der Abzweigstelle 14 angeordnet. Hierdurch wird das Kühlmittel in allen Kühlkreisen 7, 8 mittels der gemeinsamen Fördereinrichtung 15 gefördert. In der Folge lassen sich der Bauraum und das Gewicht sowie die Kosten für das Kühlsystem 1 reduzieren. Zudem kann das Kühlsystem 1 aufgrund der gemeinsamen Fördereinrichtung 15 sparsamer bzw. effizienter betrieben werden. Die Ausführungsform der Figur 4 nutzt die Tatsache, dass für die Kühlung der Halbleiterkomponente 5 ein hoher Volumenstrom (bspw. 240 l/min) angestrebt wird. Während für die Kühlung der induktiven Komponente 6 geringere Volumenströme (bspw. 100 l/min) ausreichen. Demnach wird der gesamte Kühlmittelstrom nach dem Austritt aus dem Kühler 10 durch die Halbeiterkomponente 5, die das niedrigsten Temperaturniveau benötig, gefördert. Am Austritt dieser Komponente 5 wird ein Kühlmittelstrom an der Abzweigstelle 14 in den Kühlkreis 8 für die induktiven Komponenten 6, die ein höheres Temperaturniveau erlauben, abgezweigt und dort weiter erwärmt.

Beide Ströme werden getrennt in den Kühler 10 geführt und zwar so, dass das kühlere Kühlmittel aus dem Kühlkreis 7 im Lufteintrittsbereich des Kühlers 10 seine Wärme abgibt und das wärmere Kühlmittel aus dem Kühlkreis 8 im Luftaustrittsbereich. Somit ergibt sich eine hohe thermische Effizienz, da beide Bereiche des Kühlers 10 eine gleichmäßig hohe treibende Temperaturdifferenz zwischen Luft und Kühlmittel aufweisen. Dabei wird die Kühlmittelführung im Kühler 10 zweckmäßigerweise so gestaltet, dass der Teil mit der niedrigeren Temperatur einen höheren kühlmittelseitigen Druckverlust mit entsprechend verbessertem Wärmeübergang aufweist und somit den Druckverlust der Komponente mit dem höheren Temperaturniveau ausgleicht.

Das Kühlmittel verlässt in diesem Fall den Kühler 10 beispielsweise mit ca. 55 °C und wird nach der Halbleiterkomponente 5 auf ca. 60 °C erwärmt. Der durch die induktive Komponente 6 strömende Kühlmittelstrom erwärmt sich in dieser auf ca. 75 °C, wobei die Komponente 6 mit einem Volumenstrom von beispielsweise ca. 100 l/min durchströmt wird.

## Patentansprüche

1. Kühlsystem (1) eines Fahrzeugs (2), insbesondere eines Schienenfahrzeugs (2'),
- mit einem ersten Kühlkreis (7), in dem ein Kühlmittel zirkuliert,
- mit einem zweiten Kühlkreis (8), in dem das Kühlmittel zirkuliert,
- mit einer zur Kühlung im ersten Kühlkreis (7) angeordneten ersten Wärmequelle (4'),
- mit einer zur Kühlung im zweiten Kühlkreis (8) angeordneten zweiten Wärmequelle (4"),
wobei
- das Kühlsystem (1) einen Kühler (10) zum Kühlen des Kühlmittels im ersten Kühlkreis (7) und zweiten Kühlkreis (8) aufweist,
- das Kühlsystem (1) einen Hauptzweig (12) aufweist, in dem der erste Kühlkreis (7) und der zweite Kühlkreis (8) gemeinsam geführt sind,
- im Hauptzweig (12) eine Fördereinrichtung (15) zum Fördern des Kühlmittels angeordnet ist,
- der erste Kühlkreis (7) und der zweite Kühlkreis (8) stromab der Fördereinrichtung (15) aus dem Hauptzweig (12) abzweigen,
**dadurch gekennzeichnet,**
**dass** die Kühlkreise (7, 8) innerhalb des Kühlers (10) gänzlich getrennt geführt sind.

2. Kühlsystem nach Anspruch 1,
**dadurch gekennzeichnet,**
**dass** die Fördereinrichtung (15) stromab des Kühlers (10) angeordnet ist.

3. Kühlsystem nach Anspruch 1,
**dadurch gekennzeichnet,**
**dass** die Fördereinrichtung (15) stromauf des Kühlers (10) angeordnet ist.

4. Kühlsystem nach Anspruch 3,
**dadurch gekennzeichnet,**
- **dass** der Kühler (10) als ein Zirkulationskühler (17) ausgebildet ist, durch den das Kühlmittel in Zirkulationsschleifen zirkuliert,
- **dass** im Kühler (10) für den ersten Kühlkreis (7) mehr Zirkulationsschleifen vorgesehen sind als für den zweiten Kühlkreis (8).

5. Kühlsystem nach einem der Ansprüche 1 bis 4,
**dadurch gekennzeichnet,**
**dass** der Kühler (10) zum Kühlen des Kühlmittels in einer Kühlfluid-Strömungsrichtung (11) von einem Kühlfluid, insbesondere von Luft, durchströmbar ist.

6. Kühlsystem nach Anspruch 5,
**dadurch gekennzeichnet,**
**dass** der erste Kühlkreis (7) in Kühlfluid-Strömungsrichtung (11) stromauf des zweiten Kühlkreises (8) durch den Kühler (10) geführt ist.

7. Kühlsystem nach einem der Ansprüche 1 bis 6,
**dadurch gekennzeichnet,**
**dass** zumindest ein weiterer Kühlkreis (9) vorgesehen ist, in dem das Kühlmittel zirkuliert und in dem zur Kühlung eine weitere Wärmequelle (4) angeordnet ist, wobei der weitere Kühlkreis (9) im Hauptzweig (12) mit dem ersten und dem zweiten Kühlkreis (7, 8) gemeinsam geführt ist und stromab der Fördereinrichtung (15) aus dem Hauptzweig (12) abzweigt.

8. Kühlsystem nach einem der Ansprüche 1 bis 7,
**dadurch gekennzeichnet,**
**dass** zumindest eine der Wärmequellen (4) eine Antriebskomponente (3) des Fahrzeugs (2) ist.

9. Kühlsystem nach einem der Ansprüche 1 bis 8,
**dadurch gekennzeichnet,**
**dass** die erste Wärmequelle (4') einen höheren Kühlungsbedarf aufweist als die zweite Wärmequelle (4").

## Claims

1. A cooling system (1) of a vehicle (2), in particular of a rail vehicle (2'),
- with a first cooling circuit (7), in which a coolant circulates,
- with a second cooling circuit (8), in which the coolant circulates,
- with a first heat source (4') arranged for cooling in the first cooling circuit (7),
- with a second heat source (4") arranged for cooling in the second cooling circuit (8),
wherein
- the cooling system (1) has a cooler (10) for cooling the coolant in the first cooling circuit (7) and second cooling circuit (8),
- the cooling system (1) has a main branch (12), in which the first cooling circuit (7) and the second cooling circuit (8) are directed together,
- in the main branch (12) a conveying device (15) is arranged for conveying the coolant,
- the first cooling circuit (7) and the second cooling circuit (8) branch off from the main branch (12) downstream of the conveying device (15),
**characterized in that**
the cooling circuits (7, 8) are directed entirely separately within the cooler (10).

2. The cooling system according to Claim 1,
**characterized in that**
the conveying device (15) is arranged downstream of the cooler (10).

3. The cooling system according to Claim 1,
**characterized in that**
the conveying device (15) is arranged upstream of the cooler (10).

4. The cooling system according to Claim 3,
**characterized in that**
- the cooler (10) is configured as a circulation cooler (17), through which the coolant circulates in circulation loops,
- in the cooler (10) for the first cooling circuit (7) more circulation loops are provided than for the second cooling circuit (8).

5. The cooling system according to one of Claims 1 to 4,
**characterized in that**
the cooler (10) for cooling the coolant in a cooling fluid flow direction (11) is able to be flowed through by a cooling fluid, in particular air.

6. The cooling system according to Claim 5,
**characterized in that**
the first cooling circuit (7) is directed in cooling fluid flow direction (11) upstream of the second cooling circuit (8) through the cooler (10).

7. The cooling system according to one of Claims 1 to 6,
**characterized in that**
at least one further cooling circuit (9) is provided, in which the coolant circulates and in which a further heat source (4) is arranged for cooling, wherein the further cooling circuit (9) is directed in the main branch (12) together with the first and the second cooling circuit (7, 8) and branches off from the main branch (12) downstream of the conveying device (15).

8. The cooling system according to one of Claims 1 to 7,
**characterized in that**
at least one of the heat sources (4) is a drive component (3) of the vehicle (2).

9. The cooling system according to one of Claims 1 to 8,
**characterized in that**
the first heat source (4') has a higher cooling requirement than the second heat source (4").

## Revendications

1. Système de refroidissement (1) d'un véhicule (2), en particulier d'un véhicule ferroviaire (2'), comportant
- un premier circuit de refroidissement (7) dans lequel un agent de refroidissement circule,
- un second circuit de refroidissement (8) dans lequel l'agent de refroidissement circule,
- une première source de chaleur (4') disposée pour le refroidissement dans le premier circuit de refroidissement (7),
- une seconde source de chaleur (4") disposée pour le refroidissement dans le second circuit de refroidissement (8),
dans lequel
- le système de refroidissement (1) présente un refroidisseur (10) pour refroidir l'agent de refroidissement dans le premier circuit de refroidissement (7) et le second circuit de refroidissement (8),
- le système de refroidissement (1) présente une branche principale (12) dans laquelle le premier circuit de refroidissement (7) et le second circuit de refroidissement (8) sont guidés ensemble,
- un dispositif de transport (15) servant à transporter l'agent de refroidissement est disposé dans la branche principale (12),
- le premier circuit de refroidissement (7) et le second circuit de refroidissement (8) bifurquent de la branche principale (12) en aval du dispositif de transport (15),
**caractérisé en ce que**
les circuits de refroidissement (7, 8) sont guidés entièrement à l'intérieur du refroidisseur (10).

2. Système de refroidissement selon la revendication 1,
**caractérisé en ce que**
le dispositif de transport (15) est disposé en aval du refroidisseur (10).

3. Système de refroidissement selon la revendication 1,
**caractérisé en ce que**
le dispositif de transport (15) est disposé en amont du refroidisseur (10).

4. Système de refroidissement selon la revendication 3,
**caractérisé en ce que**
- le refroidisseur (10) est réalisé sous forme d'un refroidisseur à circulation (17) à travers lequel l'agent de refroidissement circule dans des boucles de circulation,
- dans le refroidisseur (10) destiné au premier circuit de refroidissement (7), il est prévu plus de boucles de circulation que pour le second circuit de refroidissement (8).

5. Système de refroidissement selon une des revendications 1 à 4,
**caractérisé en ce que**
le refroidisseur (10), pour refroidir l'agent de refroidissement, peut être parcouru dans un sens d'écoulement de fluide de refroidissement (11) par un fluide de refroidissement, en particulier de l'air.

6. Système de refroidissement selon la revendication 5,
**caractérisé en ce que**
le premier circuit de refroidissement (7) est guidé dans le sens d'écoulement de fluide de refroidissement (11) en amont du second circuit de refroidissement (8) à travers le refroidisseur (10).

7. Système de refroidissement selon une des revendications 1 à 6,
**caractérisé en ce**
**qu'**il est prévu au moins un autre circuit de refroidissement (9) dans lequel l'agent de refroidissement circule et dans lequel une autre source de chaleur (4) est disposée pour le refroidissement, l'autre circuit de refroidissement (9) étant guidé dans la branche principale (12) en commun avec les premier et second circuits de refroidissement (7, 8) et bifurquant de la branche principale (12) en aval du dispositif de transport (15) .

8. Système de refroidissement selon une des revendications 1 à 7,
**caractérisé en ce**
**qu'**au moins une des sources de chaleur (4) est un composant d'entraînement (3) du véhicule (2).

9. Système de refroidissement selon une des revendications 1 à 8,
**caractérisé en ce que**
la première source de chaleur (4') présente un besoin de refroidissement plus élevé que la seconde source de chaleur (4").
